# EUROPÄISCHE PATENTANMELDUNG

(11) **EP 2 492 704 A1**
(43) Veröffentlichungstag der Anmeldung: **29.08.2012**
(21) Anmeldenummer: 11155991.0
(22) Anmeldetag: 25.02.2011
(51) Int. Cl.: G01R 33/48, G01R 33/563

(54) **MRT-Flussmessung mit zusätzlichem Sensor zur VENC-Einstellung**

(71) Anmelder: MAX-DELBRÜCK-CENTRUM FÜR MOLEKULARE MEDIZIN, 13125 Berlin (DE)
(72) Erfinder: Winter, Lukas, 13187 Berlin (DE); Niendorf, Thoralf, 52074 Aachen (DE)
(74) Vertreter: Lange, Sven

(57) **Zusammenfassung**

Ein Magnetresonanztomographiesystem (1) zur Untersuchung eines Körpers (2) umfasst einen Sensor (3) zum Messen des Fließverhaltens einer Körperflüssigkeit, eine MRT-Vorrichtung (4) zum Untersuchen des Körpers (2), die für eine MRT-Flußmessung eingerichtet ist und eine Steuerung (5) zum Überprüfen und Einstellen eines die Bildgebung bestimmenden Parameters (VENC) der MRT-Vorrichtung (4) in Abhängigkeit von dem gemessenen Fließverhalten.

## Beschreibung

Die Erfindung betrifft ein Magnetresonanztomographiesystem und ein Verfahren zur Untersuchung eines Körpers, sowie die Verwendung des Systems.

Erkrankungen des Herzens und der Gefäße zählen weltweit zu den häufigsten Todesursachen. Moderne Magnetresonanzbildgebungsverfahren (MRT) spielen eine zentrale Rolle für die verbesserte nicht-invasive Diagnostik von Herz- und Gefäßerkrankungen. Kardiovaskuläre MR-Tomographie ist zur Untersuchung der Anatomie und Funktion des Herzens, zur Herzmuskelvitalitätsdiagnostik, zur nicht-invasiven Darstellung der Herzkranzgefäße und zur röntgen-strahlenfreien MR-Angiographie klinisch etabliert. Weiterhin gehören Flussmessungen mittels Phasenkontrasttechniken in der kardialen MRT zum Standardrepertoire. Beispielsweise wird neben der Quantifizierung intra-und extrakardialer Shuntvolumina oder der Beurteilung von Klappenventilen eine Abschätzung von Stenosen in der Gefäßdiagnostik ermöglicht.

Die MRT basiert auf dem physikalischen Phänomen der Kernspinresonanz und wird als bildgebendes Verfahren seit über 15 Jahren in der Medizin und in der Biophysik erfolgreich eingesetzt. Bei dieser Untersuchungsmethode wird das Objekt einem starken, konstanten Magnetfeld ausgesetzt. Dadurch richten sich die zuvor regellos orientierten Energiezustände der Kernspins der Atome entsprechend parallel oder antiparallel zum Magnetfeld aus. Hochfrequenzwellen können nun diese "geordneten" Kernspins aus Ihrem Gleichgewichtszustand bringen und Übergänge zwischen den Energieniveaus anregen.. Bei der Rückkehr in den Gleichgewichtszustand wird das eigentliche MRT-Messsignal, welches mittels geeigneter Empfangsspulen aufgenommen wird erzeugt. Durch den Einsatz inhomogener Magnetfelder, erzeugt durch Gradientenspulen, kann dabei das Messobjekt in alle drei Raumrichtungen räumlich kodiert werden, was im Allgemeinen als "Ortskodierung" bezeichnet wird. Bei geschwindigkeitsaufgelösten Flussmessungen in der MagnetresonanzTomographie kann entweder der Verlauf der mittleren Geschwindigkeit des fließenden Mediums in einem bestimmten Gefäß während eines Bewegungszyklusses (Atmung, Herzbewegung) bestimmt werden oder die Geschwindigkeitsverteilung im Querschnitt des interessierenden durchflossenen Gefäßbereiches zu einem definierten Zeitpunkt der Bewegung. Von großem Interesse ist beispielsweise der Geschwindigkeitsverlauf des Blutes in der Aorta während eines Herzzyklus (von Systole zu Systole).

Die Geschwindigkeits-Abhängigkeit des Kernresonanzsignals beruht auf mehreren Effekten:
(i) der Spindichte, (ii) dem Sättigungszustand der Magnetisierung und (iii) der Modulation der Resonanzfrequenz (Larmorfrequenz) in Abhängigkeit vom Bewegungszustand der Spins. Um eine optimale Geschwindigkeitsempfindlichkeit bzw. Auflösung der Geschwindigkeit bzw. der Geschwindigkeitsverteilung zu erhalten, sollte das vorliegende Geschwindigkeitsintervall der fließenden Materie bekannt sein, um in Abhängigkeit von der Schichtdicke, des Flipwinkels und weiteren Mess- bzw. Sequenzparametern eine entsprechend optimierte Geschwindigkeitskodierung vornehmen zu können.

Zur exakten Bestimmung der Fließgeschwindigkeit erfolgt eine flusskodierte Messung. Dabei wird über eine geeignete Gradientenschaltung eine effektive Phasendifferenz sich bewegender Spins erzeugt und gemessen. Die erzeugte Phase hängt von der Fließgeschwindigkeit und dem Flächenintegral der Gradienten ab. Um eine maximale Phasen- und damit Geschwindigkeitssensitivität zu erhalten, muss die Stärke der flußkodierenden Gradienten optimal an die Geschwindigkeit der Spins angepasst werden. Die Phasendifferenz der schnellsten Spinpakete von +/-180° - die man auch als dynamischen Bereich bezeichnet - sollte dem angegebenen Geschwindigkeitsbereich entsprechen. Diese Kodiergeschwindigkeit wird als "encoding velocity" oder VENC bezeichnet. Wird diese Geschwindigkeit zu niedrig gewählt, d.h. Teile der Spinpakete bewegen sich schneller, so wird der dynamische Bereich von +/-180° überschritten, so dass Phasenverschiebungen von mehr als +/-180° entstehen. Als Folge geht die Eindeutigkeit der Zuordnung von Phase und Geschwindigkeit verloren, da Phaseneinfaltungen - die auch als Aliasing bezeichnet werden entstehen. Eine zu hoch eingestellte Geschwindigkeit führt zu einer unzureichenden Ausnutzung des dynamischen Bereiches von +/-180°. Dies kann zu einer geringeren Auflösung von Geschwindigkeitsabstufungen und/oder Verfälschung der Maximalgeschwindigkeit durch überlagertes Rauschen führen.

Im Stand der Technik muss der Anwender die Fließgeschwindigkeit bspw. des Blutes in dem zu messenden Gefäß abschätzen. Die Fließgeschwindigkeit variiert sehr stark in Abhängigkeit von der anatomischen Lage und vom (patho)physiologischen Zustand. Zum Beispiel differiert die Maximalgeschwindigkeit des Blutes in der Aorta im hohen Maße von der in kleineren, peripheren Gefäßen oder in stenotischen Gefäß-Bereichen. Der Anwender stellt daher Erfahrungswerte ein, um den gesamten Geschwindigkeitsbereich abzudecken, wodurch häufig ein zu großes Intervall definiert wird. Daraus folgt eine nur suboptimale Geschwindigkeitsauflösung.

Weiterhin sind im Stand der Technik Verfahren beschrieben, um eine Aufnahme flusskodierter Bilddaten zu verbessern. Die DE 102 56 209 A1 offenbart eine Ermittlung des VENC Parameters durch Übersichtsmessungen aus einer zusätzlichen Serie unterschiedlich flusskodierter Bilder. Das US-Patent US 006317620 B1 beschreibt eine andere MR basierte Methode, bei der die Flußkodierung in zusätzlichen, flusskodierten Kalibrierungsmessungen solange erhöht wird, bis der dynamische Bereich ausgeschöpft ist und Phaseneinfaltungen auftreten. Hierdurch ist ein Rückschluss auf eine geeignete VENC Einstellung möglich. Nachteilig an den MR-basierten Ansätzen ist der Zusatzaufwand über zusätzliche flusskodierte Kalibrierungsmessungen. Einen weiteren Nachteil stellt die nicht vorhandene Dynamik dieser Methoden dar. Bei einer Veränderung der Flussgeschwindigkeit während der Messung ist somit eine optimale Geschwindigkeitskodierung ausgeschlossen, es sei denn es werden weitere MR-basierte VENC-Kalibrierungen durchgeführt.

Weiterhin offenbart JP 10295667 A eine Methode, welche externe Sensorik hinzuzieht. Hierbei wird ein Elektrokardiogram (EKG) des Patienten aufgezeichnet. Apriori wird der Zusammenhang zwischen Phase im Herzzyklus und Blutflussgeschwindigkeit angenommen. Dieser Zusammenhang wird während der laufenden MR Messungen für die Einstellung der VENC Parameter verwendet. Bei dem beschriebenen EKG Verfahren wird die Blutflussgeschwindigkeit durch a priori Messungen bestimmt oder durch empirische Daten geschätzt. Bei der eigentlichen Messung kann dieses Verfahren somit nicht im Zielgebiet platziert werden und auf dynamische Blutflussänderungen reagieren. Ein weiterer Nachteil ist der erhöhte Zeitaufwand der Voruntersuchungen und die erhöhte Ungenauigkeit der VENC Parameter bei sich ändernden äußeren Umständen wie beispielsweise bei der Patientenlagerung in der Voruntersuchung in Relation zur Patientenpositionierung beim eigentlichen MR-Scan. Außerdem steigt die Ungenauigkeit des Verfahrens durch die Störanfälligkeit des EKGs speziell bei hohen Magnetfeldstärken. Somit wird ein Abgleich der Blutflussgeschwindigkeit mit der Herzschlagphase über eine EKG Messung sehr fehleranfällig.

Es war demgemäß Aufgabe der Erfindung, ein MRT-System bereitzustellen, welches nicht die Nachteile oder Mängel des Stands der Technik aufweist.

Gelöst wird die Aufgabe durch die unabhängigen Ansprüche. Vorteilhafte Ausführungsformen ergeben sich aus den Unteransprüchen.

Gemäß einem ersten Aspekt der Erfindung umfasst ein Magnetresonanztomographiesystem zur Untersuchung eines Körpers einen Sensor zum Messen des Fließverhaltens einer Körperflüssigkeit, eine MRT-Vorrichtung zum Untersuchen des Körpers und eine Steuerung zum Überprüfen eines die Bildgebung/Spektroskopie bestimmenden Parameters der MRT-Vorrichtung in Abhängigkeit von dem gemessenen Fließverhalten. MRT bezeichnet im Sinne der Erfindung insbesondere eine Magnetresonanztomographie. Mit dem erfindungsgemäßen Magnetresonanztomographiesystem ist ein Effizienzgewinn möglich, da keine zusätzlichen MR-Messungen zur Kalibrierung notwendig sind. Zudem kann der dynamische Bereich optimal ausgenutzt werden, was zu einer stetig hohen Auflösung der Bildgebung führt. Da der oder die die Bildgebung bestimmenden Parameter auch kontinuierlich angepasst werden können, sind dynamische Untersuchungen zum Beispiel bei sich ändernden physiologischen Bedingungen möglich. Der Parameter kann zum Beispiel die Kodiergeschwindigkeit, eine Phasenanpassung, einen Gradienten des MRT, eine Flusskompensation oder den Verzicht darauf umfassen. Generell kommt jeder Parameter, der die MR-Untersuchung beeinflusst, in Betracht. Durch das System ist überraschenderweise eine dynamische manuelle oder automatische Anpassung der VENC-Parameter insbesondere bei flusskodierten Messungen möglich.

Ein Körper bezeichnet im Sinne der Erfindung insbesondere einen materiellen Teil eines Individuums, insbesondere einen menschlichen Körper, einen Tierkörper oder einen pflanzlichen Körper.

Der Sensor kann bevorzugt zur Messung einer Fließgeschwindigkeit von Blut ausgebildet sein. Bei vielen Untersuchungen ist dies ein aussagekräftiger Wert. Alternativ oder zusätzlich kann die Beschleunigung von Blut und/oder anderen Körperflüssigkeiten wie zum Beispiel Liquor gemessen werden.

Das Magnetresonanztomographiesystem kann in einer bevorzugten Ausführungsform eine Daten des Sensors verarbeitende Rechnereinheit zur Ermittlung des Fließverhaltens umfassen. Die Rechnereinheit kann entweder ein bereits vorhandener Rechner zum Beispiel der MRT-Vorrichtung sein oder ein spezieller Rechner wie zum Beispiel ein Computer oder ein eingebettetes System. Die Datenverarbeitung kann aus einer reinen Signalverarbeitung wie zum Beispiel Anpassen der Pegel und/oder einer Berechnung von Messdaten abgeleiteten Größen bestehen.

Die MRT-Vorrichtung und/oder die Steuerung kann bevorzugt ein Ausgabeelement zur optischen Darstellung des die Bildgebung bestimmenden Parameters und/oder des Fließverhaltens umfassen. Beispielsweise über ein Display kann ein Benutzer über die Untersuchung oder bestimmte Details informiert werden, um diese kontrollieren und gegebenenfalls eingreifen zu können.

Es kann bevorzugt sein, dass die MRT-Vorrichtung und/oder die Steuerung ein Eingabeelement zur Anpassung des die Bildgebung bestimmenden Parameters durch einen Benutzer des Magnetresonanztomographiesystems umfassen. In diesem Modus kann der Benutzer den Vorgang steuern. Entweder kann der Benutzer den oder die Parameter direkt eingeben oder einen vorgeschlagenen Wert bestätigen oder abändern.

Die Steuerung kann bevorzugt den die Bildgebung bestimmenden Parameter automatisch anpassen. In diesem Fall übernimmt die Steuerung den Ablauf. Der Benutzer kann trotzdem informiert werden und/oder die Möglichkeit haben einzugreifen.

Die Messung der Fließgeschwindigkeit in einem Zielgebiet erfolgt bevorzugt über geeignete nicht-invasive Sensorik. Je nach Funktionsweise ist eine lokalisierte Bestimmung z. B. der Fließgeschwindigkeit über ein Sensorelement oder über mehrere Sensorelemente möglich. Der Sensor kann bevorzugt eine nicht invasive Sensorik, zwei Sensorelemente mit definiertem Abstand zueinander und/oder eine Sensormatrix mit mehreren Sensorelementen umfassen. Diese Varianten sind einfach in der Handhabung und liefern zuverlässige und aussagekräftige Messergebnisse. Sensoren können zum Beispiel Doppler-Ultraschall, akustische (zum Beispiel Schallsensoren, Drucksensoren, Mikrofone), opto-akustische und/oder photoelektrische (zum Beispiel Pulsoximeter) Sensoren sein. Der oder die Sensoren können MR-kompatibel sein. Wird ein zweiter Sensor verwendet und ist die Distanz zwischen diesen Sensoren bekannt, kann beispielsweise über den Laufzeitunterschied der Signalwellen eine Geschwindigkeit ermittelt werden. Vorteilhafterweise können auch andere MR-kompatible Sensoren verwendet werden, welche eine direkte Messung sich zeitlich ändernder Eigenschaften einer Körperflüssigkeit erlauben.

Es kann jedoch auch vorteilhaft sein, einen MHD-Sensor zu verwenden, der den MHD Effekt als Wirkprinzip nutzt. Die Magnetohydrodynamik (MHD) beschreibt im Sinne der Erfindung insbesondere das Verhalten von elektrisch leitenden Fluiden, die von magnetischen (und elektrischen) Feldern durchdrungen werden. Der MHD-Sensor ermöglicht beispielsweise eine Detektion der Herzaktivität bzw. eine Blutflussdetektion mittels elektrischer Messung im Magnetfeld eines MR-Geräts, indem Elektroden die elektrische Spannung messen, die auf Grund des Blutflusses im magnetischen Feld generiert werden. Somit kann über den MHD Effekt eine Richtungsinformation gewonnen werden.

Gemäß einem zweiten Aspekt der Erfindung umfasst ein Verfahren zur Untersuchung eines Körpers mit einem Magnetresonanztomographiesystem, mit den folgenden Schritten:
- Messen des Fließverhaltens einer Körperflüssigkeit,
- Untersuchen des Körpers mit einer MRT-Vorrichtung, und
- Überprüfen eines die Bildgebung bestimmenden Parameters der MRT-Vorrichtung in Abhängigkeit von dem gemessenen Fließverhalten.

Es gelten die gleichen Vorteile und Modifikationen wie zuvor beschrieben.

Die Fließgeschwindigkeit von Blut kann gemessen werden. Alternativ oder zusätzlich kann die Beschleunigung von Blut und/oder anderen Körperflüssigkeiten wie zum Beispiel Liquor gemessen werden.

Die Erfindung betrifft auch ein Magnetresonanztomographiesystem zur Untersuchung eines Objekts, aufweisend einen Sensor zum Messen des Fließverhaltens einer Flüssigkeit, eine MRT-Vorrichtung zum Untersuchen des Objekts und eine Steuerung zum Überprüfen eines die Bildgebung bestimmenden Parameters der MRT-Vorrichtung in Abhängigkeit von dem gemessenen Fließverhalten. Das System kann überraschenderweise zur Bildgebung und Spektroskopie von Objekten verwendet werden. Im Sinne der Erfindung bezeichnen Objekte insbesondere Gegenstände oder Sachen, die einen Raum einnehmen und eine Masse haben.

Die Erfindung betrifft weiterhin die Verwendung des Systems zur Synchronisierung einer Messung der MRT-Vorrichtung mit einer sich zeitlich ändernden Eigenschaft einer Flüssigkeit, bevorzugt einer Körperflüssigkeit. Eine Flüssigkeit bezeichnet im Sinne der Erfindung insbesondere einen Stoff im flüssigen Aggregatzustand. Im Sinne der Erfindung bezeichnet eine Körperflüssigkeit insbesondere eine, in den verschiedenen Kompartimenten des menschlichen Körpers vorkommende Flüssigkeit, einschließlich der darin gelösten Stoffe. Körperflüssigkeiten umfassen bevorzugt Blut, Lymphe, Liquor, Pleuraflüssigkeit, Perikardflüssigkeit, Peritonealflüssigkeit, Urin, Synovialflüssigkeit, Alveolarflüssigkeit, Verdauungssäfte, Sekrete, Exkrete, Flüssigkeitsausscheidungen oder weitere Flüssigkeiten eines Organismus. Wichtige makroskopische Eigenschaften von Flüssigkeiten umfassen bevorzugt Volumenausdehnung, Volumenelastizität, Druck, Dichte und dynamische Eigenschaften wie Strömungen und Geschwindigkeit.

Das System ermöglicht die Messung unterschiedlicher Eigenschaften einer Flüssigkeit. Vorteilhafterweise können mittels einem oder mehrerer Sensoren auch mehrere Eigenschaften einer Flüssigkeit in einem Vorgang gemessen werden. Es hat sich herausgestellt, dass das System insbesondere zur Messung einer sich zeitlich ändernden Eigenschaft einer Flüssigkeit verwendet werden kann. Flüssigkeiten können durch dynamische und/oder statische Eigenschaften beschrieben werden, wobei das System vorteilhafterweise zur Messung beider Eigenschaften der Flüssigkeit in der Lage ist. Hierdurch können exakte Daten der Flüssigkeit gesammelt und zur manuellen und/oder automatischen Anpassung der VENC-Parameter genutzt werden kann, wodurch die Bildgebung maßgeblich verbessert wird.

Bei jeglicher Art von bildgebenden Verfahren bei Lebewesen sind insbesondere die sich änderten Eigenschaften einer Flüssigkeit, insbesondere einer Körperflüssigkeit der zu untersuchenden Lebewesen zu berücksichtigen. Eine Änderung der Eigenschaft einer Körperflüssigkeit kann zu Verfälschungen, Artefakten oder zu grundsätzlich für die Diagnostik und Auswertung ungeeigneten Bildaufnahmen führen. Besonders deutlich wird dies am Beispiel der Herzuntersuchungen, bei denen die flüssigkeits-pumpende Aktivität des Herzens selbst kontraproduktiv ist. Eine hochqualitative Magnet-Resonanz-Darstellung von z. B. Organen erfordert die Ausschaltung unerwünschter Einflüsse, wie beispielsweise Pulsation und Blutfluss. Es war völlig überraschend, dass die Verwendung des Systems eine Bestimmung der Eigenschaften von Körperflüssigkeiten ermöglicht, wobei die Bildgebung durch eine MRT-Vorrichtung hierauf synchronisiert werden kann. Hierdurch kann die Bildqualität maßgeblich verbessert und Effekte wie beispielsweise Aliasing im Wesentlichen verhindert werden. Auch erschließen sich Anwendungsfälle, die bei einer üblichen EKG-Synchronisation in der Bildgebung nicht zugänglich waren. So können beispielsweise in-situ-Bilder von Organen und Extremitäten aufgenommen werden, bei denen die Untersuchungssituation bewusst von extern beeinflusst werden kann.

Es ist bevorzugt, dass das System zur Darstellung von Struktur und Funktion von Geweben und Organen in einem Körper verwendet wird. Es war völlig überraschend, dass durch die automatische oder manuelle Anpassung der VENC-Parameter an sich ändernde Eigenschaften einer Körperflüssigkeit eine optimale Darstellung von Geweben und Organen im Körper erreicht werden kann. Gewebe bezeichnen im Sinne der Erfindung insbesondere größere, abgegrenzte Verbände von mehr oder weniger gleichartig differenzierten Zellen und umfassen bevorzugt Bindegewebe, Muskel-, Nerven-, Epithel- und Stütz-Gewebe mit Knochen- und Knorpel-Gewebe. Durch die Verwendung des Systems können auf die Bildgebung störende Eigenschaften einer Körperflüssigkeit kompensiert werden und die von der Körperflüssigkeit durchströmten oder umströmten Geweben optimal dargestellt werden. Im Sinne der Erfindung bezeichnet ein Organ insbesondere einen aus verschiedenen Geweben zusammengesetzten Teil eines Körpers, der eine Funktionseinheit darstellt. Ein Organ kann sowohl als distinktes Körperelement (z.B. Leber) vorliegen, als auch in Form eines über den Körper verteilten Zellsystems (z. B. Blut). Organe umfassen bevorzugt Herz, Lunge, Leber, Nieren, Muskeln, Verdauungstrakt, Schilddrüse, Gehirn und Milz. Die Organe werden von mindestens einer Körperflüssigkeit umflossen und/oder durchströmt. Im Sinne der Erfindung können insbesondere auch Gefäße, umfassend Blut- oder Lymphgefäße oder sonstige Gefäße als Organ bezeichnet werden. Die strömende Flüssigkeit kann die MRT-Messung erheblich beeinflussen, so dass die Struktur oder Funktion des Organs nicht bestimmbar ist. Es war daher völlig überraschend, dass vor, während und/oder nach einer MRT-Messung Eigenschaften einer Flüssigkeit bestimmt werden können und hierdurch die VENC-Parameter einstellbar sind, wodurch wiederum die Bildgebung optimiert wird.

Die VENC-Parameter können vorteilhafterweise automatisch oder manuell eingestellt werden. Das System ermöglich eine dynamische Anpassung, d. h. die VENC-Parameter können kontinuierlich während der MRT-Messung angepasst werden. Hierdurch ist eine hochauflösende Darstellung der Struktur von Organen möglich. Außerdem kann auch die Funktion der Organe ermittelt werden, wodurch Funktionsänderungen (wie beispielweise Erkrankungen) schnell feststellbar sind.

Es ist bevorzugt, dass das System für angiographische Messungen verwendet wird. Die Angiographie bezeichnet im Sinne der Erfindung insbesondere eine Untersuchung, bei der Blutgefäße mittels bildgebenden Verfahren dargestellt werden und eine Darstellung der Arterien (Arteriographie), eine Venendarstellung (Phlebographie) oder eine Lymphgefäßdarstellung (Lymphographie) umfasst. Es war überraschend, dass das System dazu verwendet werden kann, Veränderungen von Gefäßen, insbesondere Blutgefäßen festzustellen. Somit können schnell und einfach Engstellen (Stenosen) oder Verschlüsse (Thrombose, Embolie) bestimmter Gefäße festgestellt werden.

Das System kann auch bevorzugt zur Darstellung der Herzkranzgefäße (Koronar-Angiographie) verwendet werden, bei der Verengungen (Koronare Herzkrankheit, KHK) oder Herzinfarkt feststellbar sind. Ebenso kann das System vorteilhafterweise für Angiographien der Hirndurchblutung (bei Schlaganfall) oder der Beinarterien (bei arterieller Verschlusskrankheit, pAVK) verwendet werden. Eine Angiographie der Venen (Phlebographie) kann z. B. bei vermuteter Thrombose oder bei Krampfadern angezeigt sein. Auch andere Gefäßveränderungen wie Ausstülpungen (Aneurysmen) oder Fehlbildungen lassen sich auf den Aufnahmen des bevorzugten Systems deutlich und ohne Bildfehler erkennen. Des Weiteren kann das System zur Angiographie bei Tumoren, Gefäßverletzungen oder anderen Krankheiten angewendet werden.

Es war völlig überraschend, dass das System für Messungen im Spinalkanal verwendet werden kann und diese zur Untersuchung und Abbildung des Spinalkanals herangezogen werden können. Durch das System kann die Funktionalität des Spinalkanals optimal untersucht werden, wobei auftretende sich zeitlich ändernde Eigenschaften der in dem Spinalkanal vorliegenden Flüssigkeit durch das System bestimmt und durch eine automatische oder manuelle Anpassung der VENC-Parameter kompensiert werden.

Das System kann weiterhin zur kardiovaskulären Untersuchung umfassend kardiale Morphologie, kardiale Anatomie, Funktion von Ventrikeln, Funktion von Klappen, Myokardperfusion und Myokardvitalität verwendet werden. Das System kann bevorzugt in der klinischen Kardiologie beispielsweise zur Diagnostik angeborener Herzfehler, Erkrankungen der herznahen großen Gefäße, Perikarderkrankungen, Infarktdiagnostik, Diagnostik entzündlicher Herzerkrankungen, Myokardszintigraphie, Perfusionsuntersuchungen oder Herztumoren verwendet werden. Durch das System kann eine optimale Differenzierung von Weichgewebe in Kombination mit einer hohen räumlichen und zeitliche Auflösung erreicht werden, so dass eine Untersuchung von kardialer Morphologie und Anatomie, der Funktion von Ventrikeln und Klappen, der Myokardperfusion und -vitalität möglich sind. Das System kann auch zur Diagnose der inneren Organe verwendet werden und beispielsweise die Funktionalität oder Struktur der Niere untersuchen. Hierbei werden die Bildgebung störende Eigenschaften einer Flüssigkeit durch das System bestimmt und zur Einstellung der VENC-Parameter herangezogen. Somit kann die Bildgebung beispielsweise der Niere oder des Gehirns maßgeblich verbessert werden. Bei einer Untersuchung des Gehirns können beispielsweise sich ändernde Eigenschaften des Liquors zur Anpassung der VENC-Parameter genutzt werden.

Es ist bevorzugt, dass das System in Verbindung mit einem MR-Kontrastmittel verwendet wird. Ein Kontrastmittel dient im Sinne der Erfindung insbesondere zur Verbesserung der Darstellung von Strukturen und Funktionen des Körpers in bildgebenden Verfahren wie dem MRT-Verfahren. Die bevorzugten MR-Kontrastmittel können vorteilhafterweise nicht nur zur Bildgebung sondern auch zur Erhebung weiterer Messdaten genutzt werden. Beispielsweise ermöglicht das System in Verbindung mit endogenen und/oder exogenen MR-Kontrastmitteln die Messung der Sauerstoff-Sättigung des Blutes. Weiterhin sind Substanzen als Kontrastmittel bevorzugt, die das vorhandene Gewebesignal verändern (verstärken oder abschwächen). Die Wirkung dieser Kontrastmittel ist bevorzugt indirekt, da das Kontrastmittel selbst kein Signal abgibt, sondern nur die Signalintensität in seiner Umgebung beeinflusst. Des weiteren sind Kontrastmittel bevorzugt, die selbst direkt als signalgebende (oder signalverhindernde) Substanzen im Bild sichtbar werden. Solche Kontrastmittel umfassen insbesondere Gadolinium-Chelate, Eisenoxidnanopartikel oder Manganverbindungen. Es ist weiterhin vorteilhaft, oral oder enteral applizierbare signalverändernde Kontrastmittel zur besseren Kontrastierung des Magen-Darm-Traktes zu verwenden. Diese umfassen silikonumhüllte superparamagnetische Eisenoxidnanopartikel, orale nicht resorbierbare Gadolinium-Chelate oder Manganverbindungen.

Weiterhin können auch signalgebende Kontrastmittel, die selbst direkt im MR sichtbar sind, verwendet werden. Diese umfassen insbesondere Wasser als natürliches Kontrastmittel in Verbindung mit Gelbildnern wie Guar, Carboxymethylcellulosen, Mannitol oder Polyethylenglykolen, ¹⁹Fluor-haltige Substanzen (z. B. SF₆- oder C₂F₆-Gas) oder hyperpolarisierte Stoffe, wie ³Helium, ¹²⁹Xenon oder ¹³Kohlenstoff als Kontrastmittel. Es kann auch vorteilhaft sein, signalfreie Kontrastmittel mit geringem oder keinem Protonengehalt, umfassend perfluorierte Brom-Verbindungen oder Bariumsulfat einzusetzen.

Im Folgenden wird die Erfindung anhand der Zeichnungen näher beschrieben. Es zeigen:
- Figur 1: Diagramme zur Darstellung einer flusskodierten Messung.
- Figur 2: Eine Darstellung von Aliasing-Effekten bei MR-Flussmessungen.
- Figur 3: Eine schematische Darstellung eines Magnetresonanztomographiesystems gemäß einer bevorzugten Ausführungsform.
- Figur 4: Eine schematische Darstellung eines Sensors für das Magnetresonanztomographiesystems gemäß einer bevorzugten Ausführungsform.
- Figur 5: Eine schematische Darstellung einer Verwendung des Magnetresonanztomographiesystems gemäß einer bevorzugten Ausführungsform für angiographische Messungen.

Die Zeichnungen dienen lediglich der Erläuterung der Erfindung und schränken diese nicht ein. Die Zeichnungen und die einzelnen Teile sind nicht notwendigerweise maßstäblich. Gleiche Bezugszeichen bezeichnen gleiche oder ähnliche Teile.

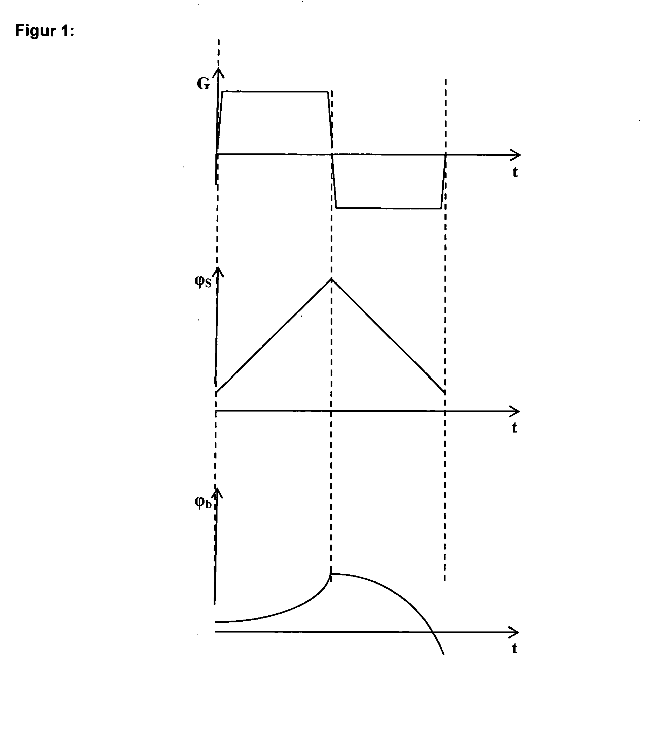

Anhand von Figur 1 wird die Bestimmung der Fließgeschwindigkeit mittels einer flusskodierten Messung erläutert. Dabei wird über eine geeignete Gradientenschaltung eine effektive Phasendifferenz sich bewegender Spins erzeugt und gemessen. In einem ersten Schritt wird ein bipolarer Gradient zur flusskodierten Messung (G) erzeugt (oberstes Diagramm von Figur 1). In der Mitte von Figur 1 ist die Phasenänderung und Refokussierung im statischen Fall (ϕₛ) dargestellt, was dem Flächenideal des Gradienten G entspricht. Im unteren Diagramm von Figur 1 ist die Phasenänderung und Netto-Phase im dynamischen Fall (ϕ_{b}) dargestellt.

Die erzeugte Phase hängt von der Fließgeschwindigkeit und dem Flächenintegral des Gradienten ab. Um eine maximale Phasen- und damit Geschwindigkeitssensitivität zu erhalten, muss die Stärke der flusskodierenden Gradienten optimal an die Geschwindigkeit der Spins angepasst werden. Die Phasendifferenz der schnellsten Spinpakete von +/-180° - die man auch als dynamischen Bereich bezeichnet - sollte dem angegebenen Geschwindigkeitsbereich entsprechen.

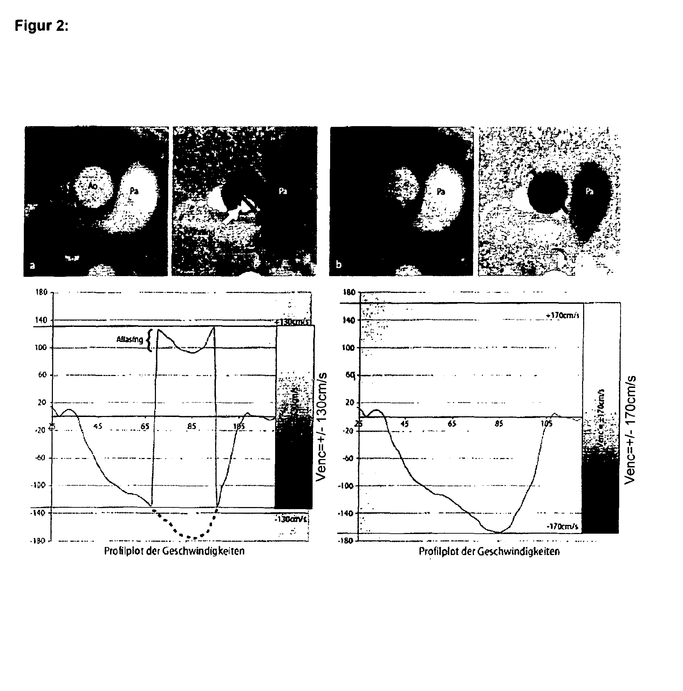

Diese Kodiergeschwindigkeit wird als "encoding velocity" oder VENC bezeichnet. Wird diese Kodiergeschwindigkeit zu niedrig gewählt , d.h. Teile der Spinpakete bewegen sich schneller, so wird der dynamische Bereich von +/-180° überschritten, was Phasenverschiebungen von mehr als +/-180° nach sich zieht. Als Folge geht die Eindeutigkeit der Zuordnung von Phase und Geschwindigkeit verloren, da Phaseneinfaltungen - die auch als Aliasing bezeichnet werden - entstehen. Figur 2 zeigt derartige Artefakte bei MR-Flussmessungen. Eine zu hoch eingestellte Kodiergeschwindigkeit führt zu einer unzureichenden Ausnutzung des dynamischen Bereiches von +/-180°. Dies kann zu einer geringeren Auflösung von Geschwindigkeitsabstufungen und/oder einer Verfälschung der Maximalgeschwindigkeit durch überlagertes Rauschen führen.

Die linke Hälfte von Figur 2, der Bereich a, zeigt beispielhaft eine Messung der Aorta mit zu geringer VENC. Die eingefalteten Geschwindigkeitsinformationen stellen sich als inverse Graustufen in der Region der höchsten Geschwindigkeiten innerhalb des Gefäßes dar. Der Profilplot entlang der im Phasenbild eingezeichneten Linie zeigt die Einfaltung der Geschwindigkeitsinformation beim Aliasing.

Die rechte Hälfte von Figur 2, der Bereich b, zeigt eine Wiederholung der Messung mit erhöhter VENC. Es tritt kein Aliasing auf. Aliasing ist nur im Phasenbild, nicht im Magnitudenbild sichtbar. Weiterhin ist die erhöhte Dynamik ersichtlich. Bei Messung a beträgt die Auflösung +/-130 cm/s, während sie in Messung b bei +/-170 cm/s liegt.

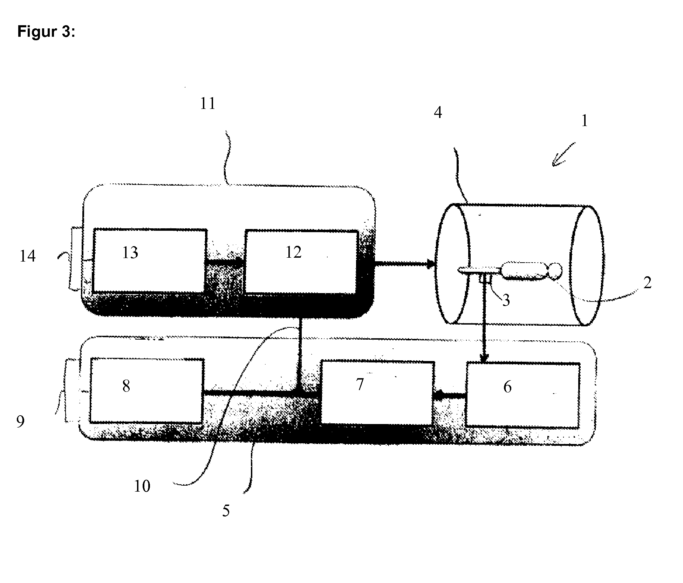

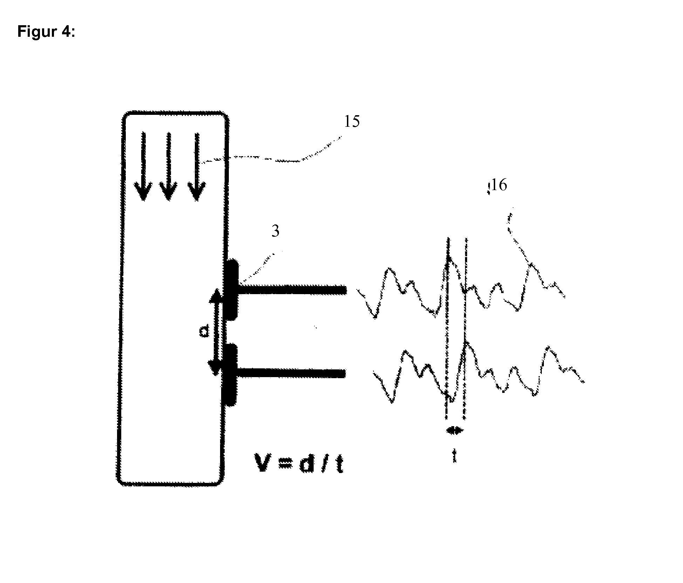

Figur 3 zeigt das Magnetresonanztomographiesystem 1 zur Untersuchung eines Körpers 2. Das MRT-System 1 umfasst einen oder mehrere Sensoren 3 zum Messen des Fließverhaltens einer Körperflüssigkeit, die in dem Körper 2 oder extern zu dem Körper 2 gemessen werden kann. Der Sensor 3 wird anhand von Figur 4 detailliert beschrieben.

Das MRT-System 1 hat eine MRT-Vorrichtung 4 zum Untersuchen des Körpers 2. Dies kann wie dargestellt ein Ganzkörper-MRT oder ein selektives MRT für bestimmte Körperregionen sein. Ein MRT für Tierkörper ist ebenfalls umfasst. Ein MRT für Materialwissenschaften und Untersuchung nichtlebender Objekte wie Leitungen, Röhren, Gefäße, poröse Medien ist ebenfalls umfasst.

Der Sensor 3 ist MR-kompatibel und kann daher auch während der MRT Untersuchung verwendet werden. Der Sensor 3 misst zum Beispiel die Fließgeschwindigkeit von Blut und gibt Sensorsignale an eine Steuerung 5 des MRT-Systems 1 aus. Die Steuerung 5 dient zur Überprüfung eines die Bildgebung bestimmenden Parameters der MRT-Vorrichtung 4 in Abhängigkeit von dem gemessenen Fließverhalten. Der Parameter kann zum Beispiel die Kodiergeschwindigkeit, eine Phasenanpassung, einen Gradienten des MRT, eine Flusskompensation oder den Verzicht darauf umfassen.

Von dem Sensor 3 kann ein physikalisches Signal ausgegeben werden, das in einer Hardware- oder Vorverarbeitungsstufe 6 in ein elektrisches Signal umgewandelt wird. In der Hardwarestufe 6 kann das Signal entsprechend gefiltert, verstärkt, manipuliert und/oder digitalisiert werden. Auch können elektrische Sensorsignale für das System angepasst werden.

Diese so bearbeiteten Sensorsignale werden dann einer Rechnereinheit 7 zugeführt. Die Hardwarestufe 6 kann bereits in der Rechnereinheit 7 integriert sein. Die Rechnereinheit 7 ermittelt aus den Daten des Sensors 3 ein Fließverhalten der Körperflüssigkeit wie zum Beispiel die Fließgeschwindigkeit beispielsweise von Blut.

Mittels eines Ausgabeelements 8 zum Beispiel in Form eines Displays wird der die Bildgebung bestimmende Parameter wie zum Beispiel die Kodiergeschwindigkeit VENC und/oder das Fließverhalten für einen Benutzer des MRT-Systems 1 dargestellt. Der Benutzer kann über ein Eingabeelement 9, wie zum Beispiel eine Tastatur, den die Bildgebung bestimmenden Parameter anpassen. Das Ausgabeelement 8 und das Eingabeelement 9 können zum Beispiel in einem Touchscreen kombiniert sein.

Über eine oder mehrere Schnittstellen 10 wird der Parameter oder die Parameter von der Steuerung 5 an eine Steuereinheit 11 der MRT-Vorrichtung 4 übergeben. Die Steuereinheit 11 umfasst einen Steuerrechner 12, der als PC ausgebildet sein kann. Der Steuerrechner 12 steuert die MRT-Vorrichtung mit Parametern an. Mit dem von der Steuerung 5 übergebenen Parameter wird die aktuelle Untersuchung durch Anpassung dieses Parameters angepasst. Entweder kann der absolute Parameterwert übergeben werden oder ein inkrementeller Parameterwert wird übergeben, der dann in dem Steuerrechner 12 verrechnet wird.

Die Anpassung kann automatisch und zu beliebigen Zeitpunkten erfolgen, das heißt vor und/oder während der MR-Messung. So wird eine optimale Geschwindigkeitssensitivität auch bei sich änderndem Fließverhalten erreicht.

Mit einem Ausgabeelement 13 zum Beispiel in Form eines Displays wird der die Bildgebung bestimmende Parameter wie zum Beispiel die Kodiergeschwindigkeit VENC und/oder das Fließverhalten für einen Benutzer des MRT-Systems 1 dargestellt. Der Benutzer kann über ein Eingabeelement 14, wie zum Beispiel eine Tastatur, den die Bildgebung bestimmenden Parameter anpassen. Das Ausgabeelement 13 und das Eingabeelement 14 können zum Beispiel in einem Touchscreen kombiniert sein. Figur 4 zeigt eine schematische Darstellung eines Sensors für das Magnetresonanztomographiesystems gemäß einer bevorzugten Ausführungsform. Die Messung einer sich zeitlich ändernden Eigenschaft eines Flusses 15 z. B. der Fließgeschwindigkeit in einem Zielgebiet kann über eine geeignete nicht-invasive Sensorik erfolgen. Je nach Funktionsweise ist eine lokalisierte Bestimmung der Fließgeschwindigkeit über einen Sensor (bspw. Doppler-Ultraschall) oder über zwei oder mehrere Sensoren 3 möglich. Ausführungsbeispiele für die Methode mit zwei Sensoren 3 können akustische (bspw. optische Mikrofone) und photoelektrische Sensoren 3 (bspw. Pulsoximeter) sein.
Hierbei wird der pulsatile Fluss durch den Sensor 3 in ein elektrisches Signal konvertiert. Wird ein zweiter Sensor 3 verwendet und ist die Distanz zwischen diesen Sensoren 3 bekannt, so kann über den Laufzeitunterschied der Signalwellen eine Geschwindigkeit ermittelt werden. Das aus dem Zielgebiet kommende physikalische Signal 16 kann dann in ein elektrisches Signal konvertiert werden. Die Konvertierung kann eine entsprechende Hardwarestufe 6 übernehmen, welche weiterhin das Signal für eine Rechnereinheit 7 aufbereitet.

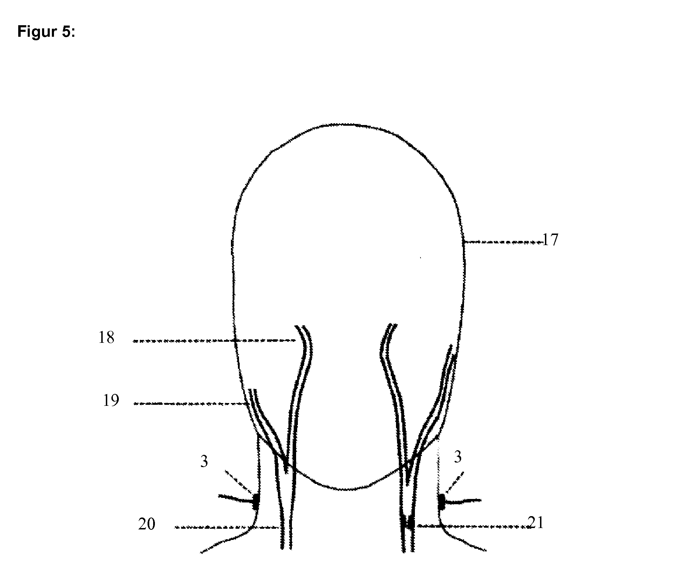

Figur 5 stellt eine schematische Darstellung einer Verwendung des Magnetresonanztomographiesystems gemäß einer bevorzugten Ausführungsform für angiographische Messungen dar. Jährlich werden etwa 150.000 Patienten wegen eines Schlaganfalls allein in deutschen Krankenhäusern behandelt. 40% aller Schlaganfälle verlaufen tödlich, wobei ca. 60% durch eine Veränderung der hirnversorgenden Gefäße, die am Cranium 17 verlaufen, verursacht wird. Eine Carotisstenose 21 ist eine Einengung der hirnversorgenden Halsschlagader 20. In der Diagnostik kann eine Magnetresonanz-Angiographie (MRA) durchgeführt werden, um eine Beurteilung der nachgeschalteten intrakraniellen Gefäßstrombahn (z. B. der internen 18 und externen carotid Arterie 19) zu erhalten. Um quantitative Aussagen über die Stenose 21 und den nachgeschalteten Blutflußverlauf zu erhalten, können weiterhin MR-flusskodierte Messungen durch eine bevorzugte Ausführungsform des Systems durchgeführt werden. Hierfür können beispielsweise Sensoren 3 im Zielgebiet platziert werden, die eine oder mehrere sich zeitlich ändernden Eigenschaften einer Körperflüssigkeit, wie beispielsweise Blut messen und eine automatische oder manuelle optimale Einstellung der VENC-Parameter ermöglichen, wodurch die Bildgebung erheblich verbessert und die Carotisstenose 21 schnell feststellbar ist.

**Bezugszeichenliste**
- 1: MRT-System
- 2: Körper
- 3: Sensor
- 4: MRT-Vorrichtung
- 5: Steuerung
- 6: Hardware- oder Vorverarbeitungsstufe
- 7: Rechnereinheit
- 8: Ausgabeelement
- 9: Schnittstelle
- 11: Steuereinheit
- 12: Steuerrechner
- 13: Weiteres Ausgabeelement
- 14: Weiteres Eingabeelement
- 15: Fluss
- 16: Signal
- 17: Cranium
- 18: Interne carotid Arterie
- 19: Externe carotid Arterie
- 20: Halsschlagader
- 21: Carotisstenose

## Patentansprüche

1. Magnetresonanztomographiesystem zur Untersuchung eines Körpers (2), aufweisend einen Sensor (3) zum Messen des Fließverhaltens einer Körperflüssigkeit, eine MRT-Vorrichtung (4) zum Untersuchen des Körpers (2) und eine Steuerung (5) zum Überprüfen eines die Bildgebung bestimmenden Parameters der MRT-Vorrichtung (4) in Abhängigkeit von dem gemessenen Fließverhalten.

2. Magnetresonanztomographiesystem nach Anspruch 1, wobei der Sensor (3) zur Messung einer Fließgeschwindigkeit von Blut ausgebildet ist.

3. Magnetresonanztomographiesystem nach Anspruch 1 oder 2, aufweisend eine Daten des Sensors (3) verarbeitende Rechnereinheit (7) zur Ermittlung des Fließverhaltens.

4. Magnetresonanztomographiesystem nach Anspruch 1 bis 3, wobei die MRT-Vorrichtung (4) und/oder die Steuerung (5) ein Ausgabeelement (8, 13) zur optischen Darstellung des die Bildgebung bestimmenden Parameters und/oder des Fließverhaltens aufweist.

5. Magnetresonanztomographiesystem nach Anspruch 1 bis 4, wobei die MRT-Vorrichtung (4) und/oder die Steuerung (5) ein Eingabeelement (9,14) zur Anpassung des die Bildgebung bestimmenden Parameters durch einen Benutzer des Magnetresonanztomographiesystems (1) aufweist.

6. Magnetresonanztomographiesystem nach Anspruch 1 bis 5, wobei die Steuerung (5) den die Bildgebung bestimmenden Parameter automatisch anpasst.

7. Magnetresonanztomographiesystem nach Anspruch 1 bis 6, wobei der Sensor (3) eine nicht invasive Sensorik, zwei Sensorelemente mit definiertem Abstand zueinander und/oder eine Sensormatrix mit mehreren Sensorelementen aufweist

8. Verfahren zur Untersuchung eines Körpers (2) mit einem
Magnetresonanztomographiesystem (1), mit den folgenden Schritten:
- Messen des Fließverhaltens einer Körperflüssigkeit,
- Untersuchen des Körpers (2) mit einer MRT-Vorrichtung (4), und
- Überprüfen eines die Bildgebung bestimmenden Parameters der MRT-Vorrichtung (4) in Abhängigkeit von dem gemessenen Fließverhalten.

9. Verfahren nach Anspruch 8, wobei die Fließgeschwindigkeit von Blut gemessen wird.

10. Verwendung des Systems nach den Ansprüchen 1 bis 7 zur Synchronisierung einer Messung der MRT-Vorrichtung (4) mit einer sich zeitlich ändernden Eigenschaft einer Körperflüssigkeit.

11. Verwendung des Systems nach Anspruch 10 zur Darstellung von Struktur und Funktion von Geweben und Organen in einem Körper (2).

12. Verwendung des Systems nach einem oder mehren der vorherigen Ansprüche, wobei die Organe ausgewählt sind aus der Gruppe umfassend Herz, Lunge, Leber, Nieren, Muskeln, Verdauungstrakt, Schilddrüse, Gehirn, Milz oder Blut.

13. Verwendung des Systems nach einem oder mehren der vorherigen Ansprüche für angiographische Messungen oder für Messungen im Spinalkanal.

14. Verwendung des Systems zur kardiovaskulären Untersuchung umfassend kardiale Morphologie, kardiale Anatomie, Funktion von Ventrikeln, Funktion von Klappen, Myokardperfusion und Myokardvitalität.

15. Verwendung des Systems nach einem oder mehren der vorherigen Ansprüche in Verbindung mit einem MR-Kontrastmittel.
